# EUROPÄISCHE PATENTSCHRIFT

(11) **EP 2 046 102 B1**
(45) Veröffentlichungstag und Bekanntmachung des Hinweises auf die Patenterteilung: **30.12.2009**
(21) Anmeldenummer: 07019293.5
(22) Anmeldetag: 01.10.2007
(51) Int. Cl.: H05K 1/02, H05K 7/20, G06F 1/20

(54) **Anordnung mit einer Baugruppe und einem Baugruppenträger**
Assembly with a module and a module rack
Agencement doté d'un module et d'un tiroir

(43) Veröffentlichungstag der Anmeldung: 08.04.2009
(73) Patentinhaber: SIEMENS AKTIENGESELLSCHAFT, 80333 München (DE)
(72) Erfinder: Sosedov, Sergej, 76137 Karlsruhe (DE)

(56) Entgegenhaltungen:
- US-A- 3 883 715
- US-A1- 2005 146 850
- US-A1- 2007 097 656

## Beschreibung

Die Erfindung betrifft eine Anordnung mit einem Baugruppenträger und mindestens einer mit einer Gehäusekapsel versehenen und auf dem Baugruppenträger montierten Baugruppe, wobei der Baugruppenträger und die Baugruppe Kontaktierungsmittel aufweisen, die thermisch miteinander verbunden sind. Darüber hinaus betrifft die Erfindung eine Baugruppe, welche für einen Einsatz in einem derartigen Baugruppenträger geeignet ist.

Die US 2007/0097656 zeigt eine Anordnung gemäß dem Oberbegriff von Anspruch 1 und eine Baugruppe gemäß dem Oberbegriff von Anspruch 4.

In Baugruppen der Automatisierungstechnik werden immer häufiger leistungsfähigere elektronische Komponenten eingesetzt, wodurch Maßnahmen zur Entwärmung der Baugruppen erforderlich sind. Gewöhnlich werden dazu in diesen Baugruppen Kühlkörper eingesetzt, insbesondere deshalb, weil in der Automatisierungstechnik Lüfter zur Wärmeableitung nicht erwünscht sind.

Aus dem Siemens-Katalog ST 70, Ausgabe 2007, Seiten 5/2 und 5/112 ist ein Automatisierungsgerät bekannt, welches mehrere Baugruppen und einen Baugruppenträger aufweist. Der Baugruppenträger ist zur Aufnahme der Baugruppen und zu deren Versorgung mit einer Betriebsspannung vorgesehen, wobei die Baugruppen in Steckplätze eines Rückwandbusses steckbar sind, über welchen die Baugruppen miteinander verbunden sind. Jeder Steckplatz des Baugruppenträgers weist an einer Kante drei parallel angeordnete und mit einem Massepotential versehene Federkontakte auf, welche mit einem Anschluss einer gesteckten Baugruppe elektrisch verbunden sind. Durch Alterung der Federkontakte und mit einer damit verbundenen Verschlechterung der Elastizität der Federkontakte oder durch eine Verschmutzung der Federkontakte erhöht sich der Kontakt- bzw. Übergangswiderstand zwischen den Federkontakten und dem dazu korrespondierenden Anschluss der jeweiligen gesteckten Baugruppe. Dadurch erhöht sich die elektrische Verlustleistung an den Kontaktstellen und ferner wird die thermische Verlustleistung der Baugruppe über den Rückwandbus nur schlecht abgeführt, wodurch sich die Temperatur in der Baugruppe erhöht. Wird eine kritische Temperatur in der Baugruppe erreicht, kann deren Betrieb gestört werden, was sich nachteilig auf den zu steuernden technischen Prozess auswirkt.

Der vorliegenden Erfindung liegt die Aufgabe zugrunde, eine Anordnung der eingangs genannten Art zu schaffen, mit welcher rechtzeitig die Güte der Wärmeableitung erkannt wird. Darüber hinaus ist eine Baugruppe anzugeben, welche für eine derartige Anordnung geeignet ist.

Diese Aufgabe wird im Hinblick auf die Anordnung mit den im kennzeichnenden Teil des Patentanspruchs 1 angegebenen, im Hinblick auf die Baugruppe mit den im kennzeichnenden Teil des Patentanspruchs 4 angegebenen Maßnahmen gelöst.

Die Erfindung geht von der Idee aus, bereits vor dem Anlauf bzw. vor dem eigentlichen Betrieb der Anordnung festzustellen, ob eine gute Wärmeleitfähigkeit zwischen den Kontaktierungsmitteln der Baugruppe und den Kontaktierungsmitteln des Baugruppenträgers als "externem" Kühlkörper sichergestellt ist. Für den Fall, dass im Vergleich zu einer gewünschten Wärmeleitung im Rahmen einer definierten Wärmezufuhr die Temperatur in der Gehäusekapsel der Baugruppe zu schnell ansteigt, weist dies darauf hin, dass die Kontaktierungsmittel die Wärme nicht ausreichend abführen und die thermische Kontaktierung schlecht ist. In diesem Fall können bereits vor dem eigentlichen Betrieb entsprechende Maßnahmen ergriffen werden, z. B. derart, dass die Baugruppe ausgetauscht und durch eine andere ersetzt wird.

In einer Ausgestaltung der Erfindung ist vorgesehen, die Kontaktierungsmittel der Baugruppe und des Baugruppenträgers flächenartig auszubilden, was eine einfache Herstellung der thermischen Kontaktierung bedeutet.

In einer weiteren Ausgestaltung der Erfindung sind die Kontaktierungsmittel oberflächenvergrößernd, z. B. sägezahnförmig, ausgebildet. Durch diese Maßnahme wird eine sehr gute thermische Verbindung erzielt.

Anhand der Zeichnung, in der ein Ausführungsbeispiel der Erfindung veranschaulicht ist, werden im Folgenden die Erfindung, deren Ausgestaltungen sowie Vorteile näher erläutert.

Es zeigen:
- Figur 1: Bestandteile einer Baugruppe und eines Baugruppen- trägers und
- Figur 2: Bestandteile eines Automatisierungsgerätes.

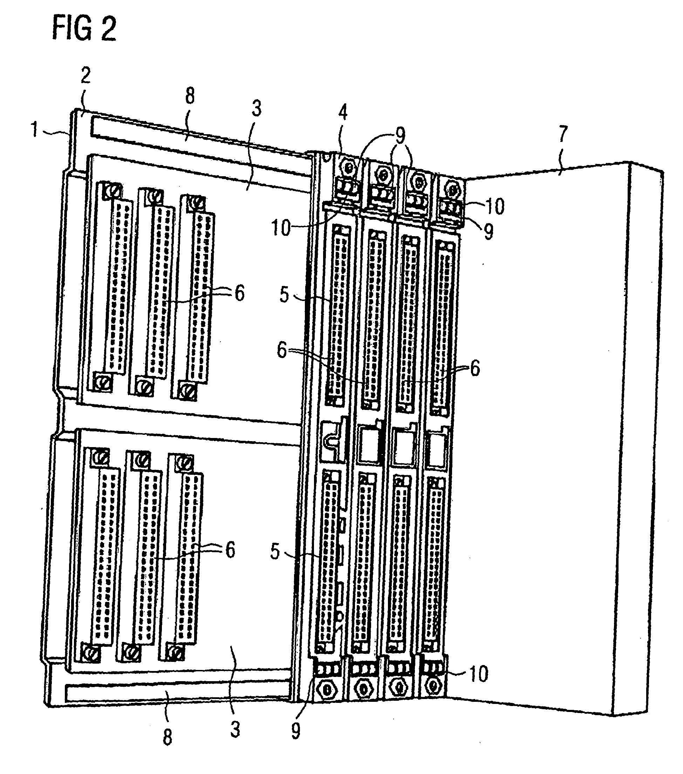

Es wird zunächst auf Figur 2 verwiesen, in welcher Bestandteile eines an sich bekannten Automatisierungsgerätes dargestellt sind. Ein Baugruppenträger 1 umfasst einen Aluminiumträger 2, zwei auf diesen Träger 2 montierte Busleiterplatten 3 sowie einen Kunststoffträger 4, durch dessen Öffnungen 5 Steckanschlüsse 6 der Busleiterplatten 3 zur Anschlussseite des Baugruppenträgers 1 ragen. Im dargestellten Ausführungsbeispiel ist lediglich eine mit einer Gehäusekapsel versehene Baugruppe 7 des Automatisierungsgerätes gezeigt, die auf einen der Steckanschlüsse 6 montiert ist. Der Aluminiumträger 2 ist mit zwei Massepotentialschienen 8 versehen, an die elektrisch leitende, federnde Kontaktteile 9 montiert und welche durch weitere Öffnungen 10 des Kunststoffträgers 4 geführt sind. Diese Kontaktteile 9 kontaktieren mit Kontaktierungsmitteln der gesteckten Baugruppe 7, wodurch diese Baugruppe 7 mit dem Massepotential verbunden ist, wobei ferner über diese Kontaktierungsmittel die thermische Verlustleistung der Baugruppe 7 zur Massepotentialschiene 8 abgeführt wird. Weitere Bestandteile der Baugruppe 7, wie beispielsweise eine mit mehreren elektronischen Bauelementen versehene Leiterplatte, sind für die Erfindung nicht von Bedeutung und werden daher nicht näher erläutert.

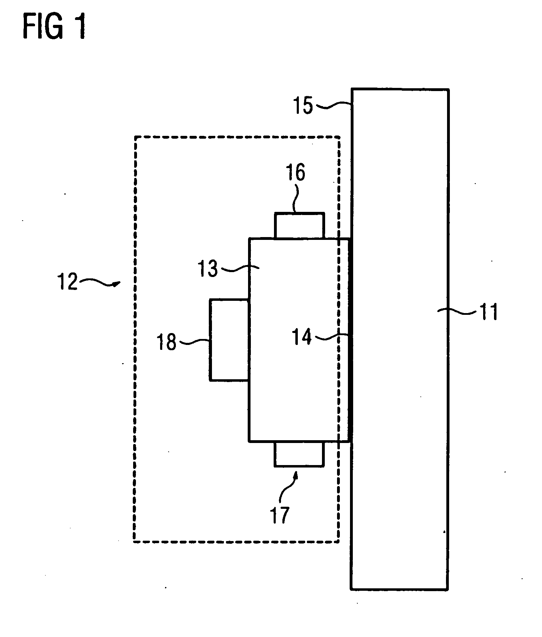

Um die Güte der Wärmeableitung zwischen den Kontaktierungsmitteln der auf den Baugruppenträger 1 gesteckten Baugruppe 7 und der Massepotentialschiene 8 zu prüfen, ist vorgesehen, in der Gehäusekapsel der Baugruppe 7 ein Heizelement, einen Temperatursensor und eine Auswerteeinheit anzuordnen. Dabei erhöht zyklisch oder nach vorgebbaren Zeiten das Heizelement die Temperatur in der Gehäusekapsel, der Temperatursensor erfasst die Temperaturerhöhung und die Auswerteeinheit prüft aufgrund der zugeführten thermischen Energie des Heizelementes und der Temperaturerhöhung bzw. der Geschwindigkeit des Temperaturanstiegs die Wärmeleitung zwischen den Kontaktierungsmitteln. In diesem Zusammenhang wird auf Figur 1 verwiesen, in welcher Bestandteile einer Baugruppe und eines Baugruppenträgers dargestellt sind.

Ein externer Kühlkörper in Form einer Massepotentialschiene 11 eines Baugruppenträgers ist zur Abführung der in einer Gehäusekapsel einer Baugruppe 12 entstehenden Wärme vorgesehen. Selbstverständlich ist es möglich, dass der Baugruppenträger selbst als Massepotentialschiene dient oder dass der Baugruppenträger selbst dazu ausgebildet ist, die Wärme der Baugruppe 12 abzuführen. Die Baugruppe 12 ist mit einem Kontaktierungsmittel 13 versehen, wobei eine Seitenfläche 14 dieses Kontaktierungsmittels 13 thermisch mit einem Teil einer Fläche 15 der Massepotentialschiene 11 verbunden ist. Es kann nun vorkommen, dass die Seitenfläche 14 des Kontaktierungsmittels 13 der auf den Baugruppenträger aufgeschwenkten Baugruppe 12 nicht ausreichend thermisch mit der Seitenfläche 15 der Massepotentialschiene 11 kontaktiert, z. B. deshalb, weil die Kontaktflächen verschmutzt sind oder weil ein hier nicht dargestellter Schwenkmechanismus der Baugruppe 12 defekt ist. Um eine derartige schlechte thermische Verbindung zwischen den Kontaktierungsmitteln 11, 13 rechtzeitig zu erkennen, führt beispielsweise vor dem Steuerbetrieb des Automatisierungsgerätes ein Heizelement 16 dem Kontaktierungsmittel 13 eine definierte thermische Energie zu, wobei ein Temperatursensor 17 eine dadurch bewirkte Temperaturerhöhung in der Gehäusekapsel bzw. des Kontaktierungsmittels 13 erfasst. Einer mit dem Temperatursensor 17 und dem Heizelement 16 verbundenen Auswerteeinheit 18 ist beispielsweise aufgrund einer Voreinstellung bekannt, um wie viel sich bei einer guten bzw. einer ausreichenden Kontaktierung der Baugruppe 7 mit der Massepotentialschiene 11 die Temperatur in der Gehäusekapsel aufgrund der zugeführten thermischen Energie erhöhen bzw. wie schnell der Temperaturanstieg sein darf, um im Rahmen einer Prozess-Steuerung einen störungsfreien Betrieb zu gewährleisten. Für den Fall, dass im Vergleich zu einer ordnungsgemäßen Wärmeleitung im Rahmen einer definierten Zufuhr thermischer Energie die Temperatur in der Gehäusekapsel der Baugruppe zu schnell ansteigt bzw. die Temperatur einen Schwellwert überschreitet, weist dies darauf hin, dass die Kontaktierungsmittel 13 die Wärme nicht ausreichend über die Massepotentialschiene 11 abführen und die thermische Kontaktierung schlecht ist. In diesem Fall sind beispielsweise die Kontaktierungsmittel 13 zu prüfen, ggf. ist die Baugruppe auszutauschen und durch eine neue Baugruppe zu ersetzen.

Es ist selbstverständlich möglich, die Güte der Wärmeableitung auch während der Steuerung eines technischen Prozesses zu prüfen. In diesem Fall ist die "normale" thermische Verlustleistung der Baugruppe während des Steuerbetriebs zu berücksichtigen, wobei entsprechende Voreinstellungen in der Auswerteeinheit 18 hinterlegt werden müssen.

## Patentansprüche

1. Anordnung mit einem Baugruppenträger (1) und mindestens einer mit einer Gehäusekapsel versehenen und auf dem Baugruppenträger (1) montierten Baugruppe (7, 12), wobei der Baugruppenträger (1) und die Baugruppe (7, 12) Kontaktierungsmittel (11, 13) aufweisen, die thermisch miteinander verbunden sind, **dadurch gekennzeichnet, dass** die Baugruppe (7) ein Heizelement (16), einen Temperatursensor (17) und eine Auswerteeinheit (18) aufweist, wobei zyklisch oder nach vorgebbaren Zeiten
- das Heizelement (16) die Temperatur in der Gehäusekapsel erhöht,
- der Temperatursensor (17) die Temperaturerhöhung erfasst und
- die Auswerteeinheit (18) aufgrund der zugeführten thermischen Energie des Heizelementes (16) und der Temperaturerhöhung oder der Temperaturanstiegsgeschwindigkeit die Wärmeleitung zwischen den Kontaktierungsmitteln (11, 13) prüft.

2. Anordnung nach Anspruch 1, **dadurch gekennzeichnet, dass** die Kontaktierungsmittel flächenartig ausgebildet sind.

3. Anordnung nach Anspruch 1, **dadurch gekennzeichnet, dass** die Kontaktierungsmittel (11, 13) oberflächenvergrößernd ausgebildet sind.

4. Baugruppe, die mit einer Gehäusekapsel versehen ist und auf einem Baugruppenträger (1) montierbar ist, wobei die Baugruppe (7) Kontaktierungsmittel (13) aufweist, die für den Fall, dass die Baugruppe (7) auf dem Baugruppenträger (1) montiert ist, mit Kontaktierungsmitteln (11) des Baugruppenträgers (1) thermisch verbunden sind, **dadurch gekennzeichnet, dass** die Baugruppe (7) ein Heizelement (16), einen Temperatursensor (17) und eine Auswerteeinheit (8) aufweist, wobei zyklisch oder nach vorgebbaren Zeiten
- das Heizelement (16) die Temperatur in der Gehäusekapsel erhöht,
- der Temperatursensor (17) die Temperaturerhöhung erfasst und
- die Auswerteeinheit (18) aufgrund der zugeführten thermischen Energie des Heizelementes (16) und der Temperaturerhöhung oder der Temperaturanstiegsgeschwindigkeit die Wärmeleitung zwischen den Kontaktierungsmitteln (11, 13) prüft.

5. Baugruppe nach Anspruch 4, **dadurch gekennzeichnet, dass** die Kontaktierungsmittel (11, 13) flächenartig ausgebildet sind.

6. Baugruppe nach Anspruch 4, **dadurch gekennzeichnet, dass** die Kontaktierungsmittel (11, 13) oberflächenvergrößernd ausgebildet sind.

## Claims

1. Arrangement with a mounting rack (1) and at least one assembly (7, 12) provided with a housing encapsulation and mounted on the mounting rack (1), wherein the mounting rack (1) and the assembly (7, 12) have contacting means (11, 13) which are thermally connected to each other, **characterised in that** the assembly (7) has a heating element (16), a temperature sensor (17) and an evaluation unit (18), wherein cyclically or in accordance with predefinable times
- the heating element (16) increases the temperature in the housing encapsulation,
- the temperature sensor (17) detects the temperature increase and
- the evaluation unit (18) checks the heat conduction between the contacting means (11, 13) on the basis of the thermal energy supplied by the heating element (16) and the temperature increase or the rate of temperature rise.

2. Arrangement according to claim 1, **characterised in that** the contacting means have a planar design.

3. Arrangement according to claim 1, **characterised in that** the contacting means (11, 13) have a surface-enlarging design.

4. Assembly which is provided with a housing encapsulation and can be mounted on a mounting rack (1), wherein the assembly (7) has contacting means (13), which, when the assembly (7) is mounted on the mounting rack (1), are thermally connected to contacting means (11) of the mounting rack (1), **characterised in that** the assembly (7) has a heating element (16), a temperature sensor (17) and an evaluation unit (8), wherein cyclically or in accordance with predefinable times
- the heating element (16) increases the temperature in the housing encapsulation,
- the temperature sensor (17) detects the temperature increase and
- the evaluation unit (18) checks the heat conduction between the contacting means (11, 13) on the basis of the thermal energy supplied by the heating element (16) and the temperature increase or the rate of temperature rise.

5. Assembly according to claim 4, **characterised in that** the contacting means (11, 13) have a planar design.

6. Assembly according to claim 4, **characterised in that** the contacting means (11, 13) have a surface-enlarging design.

## Revendications

1. Agencement comprenant un porte-module ( 1 ) et au moins un module ( 7, 12 ) muni d'une capsule de boîtier et monté sur le porte-module ( 1 ), le porte-module ( 1 ) et le module ( 7, 12 ) ayant des moyens ( 11, 13 ) de mise en contact qui sont reliés les uns aux autres thermiquement, **caractérisé en ce que** le module ( 7 ) a un élément ( 16 ) de chauffage, un capteur ( 17 ) de température et une unité ( 18 ) d'exploitation, dans lequel cycliquement ou après des temps pouvant être prescrits
- l'élément ( 16 ) de chauffage élève la température dans la capsule du boîtier,
- le capteur ( 17 ) de température relève l'élévation de température et
- l'unité ( 18 ) d'exploitation contrôle, sur la base de l'énergie thermique apportée par l'élément ( 16 ) de chauffage et de l'élévation de température ou de la vitesse d'élévation de la température, la conduction calorifique entre les moyens ( 11, 13 ) de mise en contact.

2. Agencement suivant la revendication 1, **caractérisé en ce que** les moyens de mise en contact sont constitués superficiellement.

3. Agencement suivant la revendication 1, **caractérisé en ce que** les moyens ( 11, 13 ) mise de contact sont constitués de manière à augmenter la surface.

4. Module qui est muni d'une capsule de boîtier et qui peut être monté sur un porte-module ( 1 ), le module ( 7 ) ayant des moyens ( 13 ) de mise en contact, qui, dans le cas où le module ( 7 ) est monté sur le porte-module ( 1 ), sont reliés thermiquement à des moyens ( 11 ) de mise en contact du porte-module ( 1 ), **caractérisé en ce que** le module ( 1 ) a un élément ( 16 ) de chauffage, un capteur ( 17 ) de température et une unité ( 18 ) d'exploitation, dans lequel cycliquement ou après des temps pouvant être prescrits
- l'élément ( 16 ) de chauffage élève la température dans la capsule du boîtier,
- le capteur ( 17 ) de température relève l'élévation de température et
- l'unité ( 18 ) d'exploitation contrôle, sur la base de l'énergie thermique apportée par l'élément ( 16 ) de chauffage et de l'élévation de température ou de la vitesse d'élévation de la température, la conduction calorifique entre les moyens ( 11, 13 ) de mise en contact.

5. Module suivant la revendication 4, **caractérisé en ce que** les moyens de mise en contact sont constitués superficiellement.

6. Module suivant la revendication 4, **caractérisé en ce que** les moyens ( 11, 13 ) de contact sont constitués de manière à augmenter la surface.
